# EUROPÄISCHE PATENTSCHRIFT

(11) **EP 0 314 037 B1**
(45) Veröffentlichungstag und Bekanntmachung des Hinweises auf die Patenterteilung: **23.02.1994**
(21) Anmeldenummer: 88117655.6
(22) Anmeldetag: 24.10.1988
(51) Int. Cl.: G03F 7/09

(54) **Positiv arbeitendes lichtempfindliches Gemisch, enthaltend einen Farbstoff, und daraus hergestelltes positiv arbeitendes lichtempfindliches Aufzeichnungsmaterial**
Light-sensitive positive mixture containing a dye, and light-sensitive positive registration material prepared therefrom
Mélange photosensible positif, contenant un colorant et matériau photosensible positif pour l'enregistrement préparé à partir de ce mélange

(30) Priorität: 30.10.1987 DE 3736758
(43) Veröffentlichungstag der Anmeldung: 03.05.1989
(73) Patentinhaber: HOECHST AKTIENGESELLSCHAFT, 65926 Frankfurt am Main (DE)
(72) Erfinder: Merrem, Hans-Joachim, Dr. Dipl.-Chem., D-6104 Seeheim-Jugenheim (DE)

(56) Entgegenhaltungen:
- US-A- 3 307 943
- PATENT ABSTRACTS OF JAPAN, Band 11, Nr. 68 (P-553)[2515], 28. Februar 1987, Seite 97 P 553; & JP-A-61 231 541
- JOURNAL OF THE ELECTROCHEMICAL SOCIETY, Band 134, Nr. 6, Juni 1987, Seiten 1586-1587, Manchester, New Hampshire, US; C.L. RENSCHLER et al.: "Curcumin as a positive resist dye optimized for g- and h-line exposure"

## Beschreibung

Die Erfindung betrifft ein positiv arbeitendes lichtempfindliches Gemisch, enthaltend eine lichtempfindliche Verbindung, ein wasserunlösliches, in wäßrig-alkalischer Lösung aber lösliches bzw. quellbares Bindemittel sowie einen Farbstoff.

Lichtempfindliche Gemische, die als Bindemittel einen Novolak oder ein Polyvinylphenol und als lichtempfindliche Verbindung z.B. ein o-Chinondiazid enthalten, werden seit langem bei der Herstellung von hochauflösenden Strukturen in der Fertigung von Halbleiterbauelementen eingesetzt. Aufgrund der zunehmenden Miniaturisierung der Funktionselemente werden immer höhere Anforderungen an das optische Auflösungsvermögen dieser lichtempfindlichen Gemische gestellt. Probleme sind insbesondere dann zu erwarten, wenn die Strukturierung in der Nähe der Auflösungsgrenze der optischen Belichtungssysteme erfolgt. In diesen Grenzbereichen wird die Auflösung vor allem durch optische Störeffekte, wie Interferenzerscheinungen und unerwünschte Streulichtreflektionen an der Substratoberfläche bestimmt. Derartige Effekte können z.T. durch eine Erhöhung der nicht ausbleichbaren Absorption der lichtempfindlichen Gemische vermieden werden. Dies geschieht beispielsweise durch Zugabe von im aktinischen Bereich absorbierenden Substanzen zu dem Photolack.

Der Zusatz von absorbierenden Substanzen zu lichtempfindlichen Gemischen ist seit langem bekannt. Beispielsweise wird in der EP 0 026 088 beschrieben, daß durch Zusatz von Farbstoffen zu negativ arbeitenden Photoresists eine Verbesserung der bildmäßig erzeugten Strukturen erreicht werden kann.

Der Zusatz von Farbstoffen zu positiv arbeitenden Photoresists ist erstmals von A.R. Neureuther und F.H. Dill ("Photoresist Modeling und Device Fabrication Applications", Proceedings of Symposium on Optical and Acoustical Micro-Electronics, Polytechnic Institute of New York, 16.-18.04.1974, Seiten 223-249) beschrieben worden. Danach wird durch Farbstoffzusatz vor allem die auf Interferenzeffekten beruhende Beeinträchtigung der optischen Auflösung reduziert.

Von H.L. Stover, M. Nagler, I.I. Bol und V. Miller wird in "Submicron Optical Lithography: I-line Lens and Photoresist Technology" (SPIE Proceedings, Band 470, Seiten 22-33 (1984)) beschrieben, daß die optische Auflösung durch Zusatz eines absorbierenden Farbstoffes, der im Bereich der Belichtungswellenlänge von λ = 436 nm absorbiert, deutlich verbessert wird, andererseits die Belichtungszeit zur Erzeugung von bildmäßigen Strukturen im Vergleich zu einem System ohne diese absorbierende Substanz deutlich verlängert werden muß.

In der PCT WO 86/01914 wird ein Verfahren beschrieben, bei dem ebenfalls die Erzeugung von Photoresiststrukturen durch Verwendung eines nicht ausbleichbaren, lichtabsorbierenden Zusatzes verbessert wird. Auch in diesem Fall wird darauf hingewiesen, daß die Belichtungszeit im Vergleich zu einem Photoresist ohne Zusatz um etwa 50-150 % verlängert werden muß. Als besonders bevorzugte Farbstoffe werden Cumarinderivate genannt.

Ein Cumarinderivat wird ebenfalls von I.I. Bol in "High-Resolution Optical Lithography Using Dyed Single-Layer Resist" (Proceedings Kodak Microelectronics Seminar 1984, Seiten 19-22) beschrieben und die signifikante Verbesserung der photolithographischen Eigenschaften des Photoresists bestätigt.

Der Einfluß von im aktinischen Bereich absorbierenden Substanzen auf die photolithographischen Eigenschaften von positiv arbeitenden Photoresists wird von A.V. Brown und W.H. Arnold in "Optimization of Resist Optical Density for High Resolution Lithography on Reflective Surfaces" (SPIE Proceedings, Band 539, Seiten 259-266 (1985)) und M.P.C. Watts, D. DeBruin und W.H. Arnold in "The Reduction of Reflective Notching Using Dyed Resists" (Proceedings of Seventh International Technical Conference on Photopolymers, Ellenville, N.Y., Oktober 1985, Seiten 285-296) ausführlich abgehandelt. Nach diesen Untersuchungen wird durch Zusatz von im aktinischen Bereich absorbierenden Substanzen die Löslichkeit der Photoresistgemische in den wäßrig-alkalischen Entwicklern herabgesetzt und damit die Lichtempfindlichkeit dieser Photolacke deutlich vermindert.

T.R. Pampalone und K.A. Kuyan beschreiben in "Improving Linewidth Control over Reflective Surfaces Using Heavily Dyed Resists" (Journal of the Electrochemical Society, Band 133, Heft 1, Seiten 192-196 (1986)) den Einfluß von hohen Konzentrationen an absorbierenden Substanzen im Photoresist. Nach diesen Untersuchungen werden besonders gute Ergebnisse mit Photoresists erzielt, die eine besonders hohe Absorption im aktinischen Bereich aufweisen. Auch in diesem Fall zeigt sich, daß durch Zusatz der absorbierenden Verbindung die Lichtempfindlichkeit deutlich, d.h. bis um den Faktor fünf oder mehr zurückgeht.

In der US-A 4,575,480 werden ebenfalls Photoresistformulierungen beschrieben, die im aktinischen Bereich absorbierende Substanzen enthalten. Die genannten Verbindungen zeichnen sich durch geringe Neigung zum Sublimieren sowie durch hohe Absorption im aktinischen Bereich aus. Von Nachteil ist die - je nach Konzentration des Zusatzes - zum Teil deutlich reduzierte Lichtempfindlichkeit der Photoresistformulierungen.

In analoger Weise werden in den japanischen Patentanmeldungen 86-159626/25, 86-165777/26, 86-174465/27 und 86-174466/27 Photoresistformulierungen beschrieben, die ebenfalls nicht ausbleichbare und nicht sublimierbare absorbierende Substanzen enthalten. In allen Fällen ist jedoch die Löslichkeit des belichteten Resistanteils in den Entwicklerlösungen deutlich reduziert.

Photoresists, die neben einem im aktinischen Bereich absorbierenden Farbstoff zusätzlich eine löslichkeitssteigernde Komponente, insbesondere 2,3,4-Trihydroxybenzophenon enthalten, werden in der US-A 4,626,492 genannt. Das 2,3,4-Trihydroxybenzophenon wird in Mengen von 12,8 bis 13,1 Gewichtsprozenten zugesetzt, wodurch sich allerdings die thermische Beständigkeit des Photoresists deutlich verschlechtert. Außerdem wird eine Verschlechterung der Verarbeitungsbreite des Resists beobachtet, da die Entwicklungsrate stark von der Vortrocknungstemperatur des Resistfilms abhängt.

In der DE-C 25 47 905 wird einem lichtempfindlichen Gemisch, enthaltend ein o-Chinondiazid und ein in wäßrig alkalischer Lösung lösliches Bindemittel ein Polyhydroxybenzophenon zugesetzt, worunter 2,3,4-Trihydroxybenzophenon und 2,4-Dihydroxybenzophenon zu verstehen sind. Aufgrund ihrer Eigenschaften hinsichtlich Chelatbildung sollen die Benzophenonderivate eine gute Haftung zu anodisch oxidierten Aluminiumoberflächen bei der Anwendung auf Flachdruckplatten aufweisen. Aussagen zur UV-Absorption werden nicht gemacht, sie sind auch nicht notwendig, da nicht monochromatisch belichtet wird. Verbindungen des genannten Typs absorbieren zudem nicht im gewünschten, erfindungsgemäßen Bereich.

Aufgabe der Erfindung war es daher, ein positiv arbeitendes lichtempfindliches Gemisch bereitzustellen, enthaltend einen nicht ausbleichbaren, im aktinischen Bereich absorbierenden Farbstoff, der folgende Eigenschaften zeigen bzw. bewirken soll:
- gute Löslichkeit im Lösemittel bzw. Lösemittelgemisch des lichtempfindlichen Gemischs, so daß die Bildung von unerwünschten Ausfällungen bei Lagerung des Gemischs, insbesondere bei tiefen Temperaturen, nicht eintritt,
- gute thermische Beständigkeit und geringe Neigung zum Sublimieren, um einerseits eine - auch bei hohen Temperaturen - konstante Absorption der aktinischen Strahlung zu gewährleisten und andererseits die Kontamination von Prozeßgeräten möglichst gering zu halten,
- hohe Absorption im Bereich der aktinischen Strahlung, um in effizienter Weise unerwünschte optische Effekte zu minimieren.

Gelöst wird die Aufgabe durch Bereitstellen eines positiv arbeitenden lichtempfindlichen Gemischs, enthaltend eine lichtempfindliche Verbindung, ein wasserunlösliches, in wäßrig-alkalischer Lösung aber lösliches bzw. quellbares Bindemittel sowie einen Farbstoff, dadurch gekennzeichnet, daß der Farbstoff eine bei λ = 365 ± 15 nm absorbierende, nicht ausbleichbare Verbindung der allgemeinen Formel I 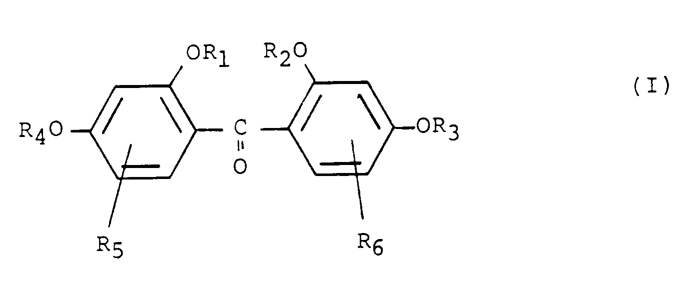
ist, worin
- R₁ bis R₄: gleich oder verschieden sind und Wasserstoff, Alkyl, Hydroxyalkyl oder Alkoxyalkyl und
- R₅ und R₆: gleich oder verschieden sind und Wasserstoff, Alkyl, Hydroxyalkyl, Alkoxyalkyl, Halogen oder Amino
bedeuten.

Verbindungen, die unter die oben genannte allgemeine Formel I fallen, zeichnen sich dadurch aus, daß sie die Anforderungen hoher Absorption im aktinischen Bereich in besonderem Maße erfüllen.

Als besonders überraschende Eigenschaften, die das erfindungsgemäße lichtempfindliche Gemisch neben den schon in der Aufgabenstellung genannten aufweist, sind zu nennen:
- eine höhere Lichtempfindlichkeit des erfindungsgemäßen lichtempfindlichen Gemischs im Vergleich zu lichtempfindlichen Gemischen, die andere, nicht beanspruchte Farbstoffe, die ebenso im aktinischen Bereich absorbieren, enthalten,
- keine oder nur geringe Reduzierung der Lichtempfindlichkeit des erfindungsgemäß lichtempfindlichen Gemischs im Vergleich zu lichtempfindlichen Gemischen, die keine bzw. andere Farbstoffe enthalten.

Insbesondere werden solche im aktinischen Bereich absorbierte Farbstoffe bevorzugt, die entsprechend der allgemeinen Formel I für
- R₁ bis R₄: Wasserstoff, (C₁-C₆)Alkyl, Hydroxy(C₁-C₃)alkyl oder (C₁-C₃)Alkoxy(C₁-C₄)alkyl und
- R₅ und R₆: Wasserstoff, (C₁-C₃)Alkyl, Hydroxy(C₁-C₃)alkyl, (C₁-C₃)Alkoxy(C₁-C₄)alkyl oder Chlor
enthalten.

Besonders bevorzugt sind diejenigen Farbstoffe der allgemeinen Formel I, bei denen
- R₁ und R₂: gleich sind und Wasserstoff oder (C₁-C₃)Alkyl,
- R₃ und R₄: gleich oder verschieden sind und Wasserstoff, (C₁-C₃)Alkyl oder Hydroxy(C₁-C₃)alkyl und
- R₅ und R₆: jeweils in meta-Position zu den Substituenten R₁ und R₄ bzw. R₂ und R₃ gebunden sind und Wasserstoff, (C₁-C₃)Alkyl, Hydroxy(C₁-C₃)alkyl oder (C₁-C₃)Alkoxy(C₁-C₂)alkyl
bedeuten.

Insbesondere bevorzugt sind diejenigen Farbstoffe der allgemeinen Formel I, bei denen
- R₁ und R₂: Wasserstoff,
- R₃ und R₄: gleich sind und Wasserstoff oder (C₁-C₃)Alkyl und
- R₅ und R₆: Wasserstoff oder in meta-Position zu den Substituenten R₁ und R₄ bzw. R₂ und R₃ gebundenes (C₁-C₃)Alkyl
bedeuten.

Von diesen Farbstoffen werden solche bevorzugt eingesetzt, deren Absorptionsvermögen möglichst genau der der aktinischen Strahlung entsprechen, vor allem solche mit einem Absorptionsmaximum bei λ = 365 ± 15 nm und besonders bevorzugt Wellenlängen von λ = 365 ± 10 nm. Dadurch wird die zum Erreichen der gewünschten Absorption erforderliche Menge an Farbstoff auf ein Minimum reduziert.

Die Konzentration des absorbierenden Farbstoffes kann von 0,05 bis 5 Gew.-%, besonders bevorzugt von 0,2 bis 0,8 Gew.-%, jeweils bezogen auf die nichtflüchtigen Bestandteile des lichtempfindlichen Gemisches, betragen.

Die jeweils eingesetzte Menge des Farbstoffs hängt naturgemäß von dem molaren Extinktionseffizienten des Farbstoffes bei der jeweiligen Belichtungswellenlänge ab. Ist der Gehalt an absorbierendem Farbstoff zu niedrig, dann werden die Reflektionseffekte nur in unzureichender Weise reduziert und keine oder nur eine geringfügige Verbesserung der photolithographischen Eigenschaften erreicht. Andererseits führt eine zu hohe Konzentration an absorbierender Verbindung zu einer Verschlechterung der Bildqualität, da die der Belichtungsquelle näher stehenden Bereiche in der Resistschicht zu stark belichtet werden, während die am Substrat befindlichen Bereiche der Schicht noch nicht ausreichend belichtet sind.

Die Herstellung der im aktinischen Bereich absorbierenden Verbindungen nach Formel (I) ist beispielsweise in "Journal of Organic Chemistry", Band 23, Seiten 1679 ff beschrieben.

Die erfindungsgemäßen lichtempfindlichen Gemische enthalten ferner eine strahlungs- bzw. lichtempfindliche Verbindung oder eine strahlungs- bzw. lichtempfindliche Kombination von Verbindungen. Geeignet sind positiv arbeitende Verbindungen, d.h. solche, die durch Belichten löslich werden. Hierzu gehören einerseits o-Chinondiazide und andererseits Kombinationen von photolytischen Säurespendern mit säurespaltbaren Verbindungen, wie z.B. Orthocarbonsäure- oder Acetalverbindungen.

o-Chinondiazide sind z.B. bekannt aus den DE-C 9 38 233 und 15 43 721, den DE-A 23 31 377, 25 47 905 und 28 28 037. Als o-Chinondiazide werden bevorzugt 1,2-Naphthochinon-2-diazid-4- oder -5-sulfonsäureester oder -amide verwendet. Von diesen werden die Ester, insbesondere die der Sulfonsäuren, besonders bevorzugt. Die Menge an o-Chinondiazidverbindungen im erfindungsgemäßen lichtempfindlichen Gemisch beträgt im allgemeinen 3 bis 50, bevorzugt 7 bis 35 Gew.-%, bezogen auf die nichtflüchtigen Anteile des Gemischs.

Von den säurespaltbaren Materialien werden eingesetzt:
a) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,
b) Oligomer- oder Polymerverbindungen mit wiederkehrenden Acetal- und/oder Ketalgruppierungen in der Hauptkette,
c) Verbindungen mit mindestens einer Enolether- oder N-Acyliminocarbonatgruppierung;
d) cyclische Acetale oder Ketale von β-Ketoestern oder -amiden;
e) Verbindungen mit Silylethergruppierungen,
f) Verbindungen mit Silenolethergruppierungen und
g) Monoacetale bzw. Monoketale, deren Aldehyd- bzw. Ketonkomponenten eine Löslichkeit im Entwickler zwischen 0,1 und 100 g/l aufweisen,
h) Ether auf Basis tertiärer Alkohole,
i) Carbonsäureester und Carbonate tertiärer, allylischer oder benzylischer Alkohole.

Durch Säure spaltbare Verbindungen des Typs a) als Komponenten strahlungsempfindlicher Gemische sind in der DE-A-29 28 636 = EP-A-0 022 571, der DE-A-26 10 842 und der US-A 4 101 323 ausführlich beschrieben; Gemische, die Verbindungen des Typs b) enthalten, sind in der DE-C-23 06 248 = US-A 3 779 778 und der DE-C-27 18 254 beschrieben; Verbindungen des Typs c) werden in den EP-A-0 006 626 und 0 006 627 beschrieben, Verbindungen des Typs d) in der EP-A-0 202 196 und Verbindungen, die dem Typ e) zuzurechnen sind, werden in den DE-A-35 44 165 und DE-A-36 01 264 vorgestellt; Verbindungen des Typs f) findet man in der am 13.09.87 eingereichten Patentanmeldung P 37 30 783.5 (Hoe 87/K060), während Verbindungen vom Typ g) in den ebenfalls am 13.09.87 eingereichten Patentanmeldungen P 37 30 785.1 (Hoe 87/K062) und P 37 30 787.8 (Hoe 87/K063 ) behandelt werden. Verbindungen vom Typ h) werden z.B. in der US-A-4 603 101 beschrieben, Verbindungen vom Typ i) z.B. in der US-A-4 491 628 und J.M. Fréchet et al., J. Imaging Sci. 30, 59-64 (1986).

Bevorzugte Verbindungen weisen C-O-C-Gruppierungen auf, die durch Säure spaltbar sind.

Von den in der US-A 4 101 323 beschriebenen Orthocarbonsäurederivaten werden besonders die Bis-1,3-dioxan-2-yl-ether von aliphatischen Diolen verwendet. Von den in der DE-C-27 18 254 beschriebenen Polyacetalen werden diejenigen mit aliphatischen Aldehyd- und Dioleinheiten bevorzugt.

Weiter gut geeignete Gemische sind in der EP-A-0 022 571 beschrieben. Dort werden als säurespaltbare Verbindungen polymere Orthoester mit wiederkehrenden Orthoestergruppen in der Hauptkette beschrieben. Diese Gruppen sind 2-Alkylether von 1,3-Dioxa-cycloalkanen mit 5 oder 6 Ringgliedern. Besonders bevorzugt werden Polymere mit wiederkehrenden 1,3-Dioxa-cyclohex-2-yl-alkylethereinheiten, in denen die Alkylethergruppe durch Ethersauerstoffatome unterbrochen sein kann und bevorzugt an die 5-Stellung des benachbarten Rings gebunden ist.

Als licht- bzw. strahlungsempfindliche Säurespender erhalten diese Gemische vorwiegend organische Halogenverbindungen.

Unter die Halogenverbindungen zählen insbesondere Triazinderivate, die aus den US-A-3 515 552, 3 536 489 und 3 779 778 sowie den DE-C-27 18 259, 33 37 024, 33 33 450, 23 06 248, 22 43 621 und 12 98 414 bekannt sind. Diese können aber auch in Kombination mit anderen Photoinitiatoren wie Oxazolen, Oxadiazolen oder Thiazolen, aber auch untereinander in Mischungen eingesetzt werden.

Es sind aber auch Oxazole, Oxadiazole, Thiazol oder 2-Pyrone bekannt, die Trichlor- oder Tribrommethylgruppen enthalten (DE-A-30 21 599, 30 21 590, 28 51 472, 29 49 396 sowie EP-A-0 135 348 und 0 135 863).

Ebenso zählen unter diesen Oberbegriff insbesondere auch aromatische Verbindungen, die kernständiges Halogen, vorzugsweise Brom aufweisen. Solche Verbindungen sind auch aus der DE-A-26 10 842 bekannt.

Der Mengenanteil der säurespaltbaren Verbindungen in dem erfindungsgemäßen lichtempfindlichen Gemisch liegt im allgemeinen bei 8 bis 65 Gew.-%, vorzugsweise bei 14 bis 44 Gew.-%, bezogen auf die nichtflüchtigen Bestandteile des Gemischs. Die Menge der säurebildenden Verbindungen liegt bei 0,1 bis 10 Gew.-%, vorzugsweise bei 0,2 bis 5 Gew.-%, ebenfalls bezogen auf die nichtflüchtigen Bestandteile des Gemischs.

Die erfindungsgemäßen Beschichtungslösungen enthalten zusätzlich zu den vorstehend beschriebenen lichtempfindlichen Bestandteilen polymere Bindemittel. Dabei werden solche Polymeren bevorzugt, die wasserunlöslich und in wäßrig-alkalischen Lösungen löslich, zumindest aber quellbar sind.

Als alkalilösliche, zumindest aber in Alkali quellbare Bindemittel sind natürliche Harze wie Schellack und Kolophonium und synthetische Harze wie Mischpolymerisate aus Styrol und Maleinsäureanhydrid oder Mischpolymerisate der Acrylsäure oder Methacrylsäure, insbesondere mit Acryl- oder Methacrylsäureestern, sowie insbesondere Novolake zu nennen.

Als Novolak-Kondensationsharze haben sich besonders die höher kondensierten Harze mit substituierten Phenolen als Formaldehyd-Kondensationspartner bewährt. Genannt werden Phenol-Formaldehydharze, Kresol-Formaldehydharze, deren Mischkondensate und deren Mischungen sowie Phenol-und Kresol-Kondensate mit Formaldehyd.

Statt oder im Gemisch mit Novolaken sind vorteilhaft auch Phenolharze vom Typ des Poly(4-vinylphenols) verwendbar.

Die Art und Menge der alkalilöslichen Harze kann je nach Anwendungszweck verschieden sein; bevorzugt sind Anteile am Gesamtfeststoffgehalt des Gemisches von 30 bis 90 Gew.-%, besonders bevorzugt von 55 bis 85 Gew.-%.

Zusätzlich können noch zahlreiche andere Harze mitverwendet werden, bevorzugt Vinylpolymerisate wie Polyvinylacetate, Poly(meth)acrylate, Polyvinylether, Polyvinylpyrrolidone sowie Styrolpolymerisate, die selbst durch Comonomere modifiziert sein können. Im besonderen sind zu nenen: Polymere von Styrol mit Einheiten von Alkenylsulfonyl-aminocarbonyloxy- oder Cycloalkenylsulfonylaminocarbonyloxy- (EP-A-0 184 804), Polymere der Acryl-, Methacryl-, Malein-, Itaconsäure etc. mit seitenständigen, vernetzenden -CH₂OR-Gruppen (EP-A-0 184 044), Polymerisate aus Vinylmonomeren mit Alkenylphenoleinheiten (EP-A-0 153 682), Polyvinylphenole als Novolakersatz (DE-C-23 22 230), polymere Bindemittel mit seitenständigen, phenolischen Hydroxylgruppen (EP-A-0 212 439 und 0 212 440), Styrol-Maleinsäureanhydrid-Mischpolymerisate (DE-A-31 30 987), Polymere aus ungesättigten (Thio)phosphinsäureiso(thio)cyanaten mit einem aktiven Wasserstoff enthaltenden Polymeren (deutsche Patentanmeldungen P 36 15 612.4 und P 36 15 613.2), Polymere mit Vinylacetat, Vinylalkohol und Vinylacetaleinheiten (EP-A-0 216 083) sowie Polyvinylacetale mit Einheiten aus Hydroxyaldehyden (deutsche Patentanmeldung P 36 44 162.7).

Der günstigste Anteil dieser Harze im Bindemittel des erfindungsgemäßen lichtempfindlichen Gemischs richtet sich nach den anwendungstechnischen Erfordernissen und dem Einfluß auf die Entwicklungsbedingungen und beträgt im allgemeinen nicht mehr als 20 Gew.-% vom alkalilöslichen Harz.

Ferner können den erfindungsgemäßen lichtempfindlichen Gemischen ggf. Farbstoffe, feinteilige Pigmente, Weichmacher, Netzmittel und Verlaufmittel, aber auch Polyglykole, Cellulosederivate, z.B. Ethylcellulose, zur Verbesserung spezieller Erfordernisse wie Flexibilität, Haftung und Glanz zugesetzt werden.

Vorzugsweise wird das erfindungsgemäße lichtempfindliche Gemisch in Lösungsmitteln wie Ethylenglykol, Glykolethern wie Glykolmonomethylether, Glykoldimethylether, Glykolmonoethylether oder Propylenglykolmonoalkylethern, insbesondere Propylenglykolmethylether; aliphatische Estern wie Ethylacetat, Hydroxyethylacetat, Alkoxyethylacetat, n-Butylacetat, Propylenglykolmonoalkyletheracetat, insbesondere Propylenglykolmethyletheracetat oder Amylacetat; Ethern wie Dioxan, Ketonen wie Methylethylketon, Methyl-iso-butylketon, Cyclopentanon und Cyclohexanon; Dimethylformamid, Dimethylacetamid, Hexamethylphosphorsäureamid, N-Methyl-pyrrolidon, Butyrolacton, Tetrahydrofuran, und in Mischungen derselben gelöst. Besonders bevorzugt werden Glykolether, aliphatische Ester sowie Ketone.

Der Gesamtfeststoffgehalt der erfindungsgemäßen Lösung liegt je nach Art der lichtempfindlichen Verbindungen und der Bindemittel sowie je nach Verwendungszweck im allgemeinen bei 10 bis 50 Gew.-%, vorzugsweise bei 15 bis 35 Gew.-%.

Erfindungsgemäß wird ferner ein lichtempfindliches Aufzeichnungsmaterial beansprucht, im wesentlichen bestehend aus einem in der Photoresisttechnik üblichen Substrat und dem darauf aufgetragenen lichtempfindlichen Gemisch.

Als Substrate kommen alle Materialien in Frage, aus denen Kondensatoren, Halbleiter, mehrlagige gedruckte Schaltungen oder integrierte Schaltkreise bestehen bzw. hergestellt werden können. Insbesondere sind Oberflächen aus Siliciummaterial zu nennen, die gegebenfalls auch dotiert sein können, einschließlich aller anderen in der Halbleitertechnologie üblichen Substrate wie beispielsweise Siliciumnitrid, Galliumarsenid, Indiumphosphid. Weiterhin kommen in Frage die aus der Flüssigkristall-display-Herstellung bekannten Substrate wie Glas, Indium-Zinnoxid; ferner Metallplatten und -folien, beispielsweise aus Kupfer, Zink; Bimetall- und Trimetallfolien, aber auch elektrisch nicht leitende Folien, die mit Metallen bedampft sind, gegebenenfalls mit Aluminium beschichtete SiO₂-Materialien und Papier. Diese Substrate können einer Temperatur-Vorbehandlung unterzogen werden, oberflächlich angerauht, angeätzt oder zur Erzielung erwünschter Eigenschaften, wie z. B. Erhöhung der Hydrophilie, mit Chemikalien behandelt sein.

In einer besonderen Ausführungsform kann das strahlungsempfindliche Gemisch zur besseren Haftung in dem Resist oder zwischen dem Resist und dem Substrat einen Haftvermittler enthalten. Bei Silicium- bzw. Siliciumdioxid-Substraten kommen hierfür Haftvermittler vom Aminosilan-Typ, wie z.B. 3-Aminopropyl-triethoxysilan oder Hexamethyl-disilazan in Frage.

Das lichtempfindliche Gemisch kann in üblicher Weise, wie z.B. durch Tauchen, Gießen, Schleudern, Sprühen, mittels Walzen oder durch Schlitzdüsen auf den zu beschichtenden Träger aufgebracht werden.

Die erfindungsgemäßen Aufzeichnungsmaterialien werden bildmäßig belichtet. Quellen aktinischer Strahlung sind: Metallhalogenidlampen, Kohlebogenlampen, Xenonlampen und Quecksilberdampflampen, deren Emissionsmaxima im nahen UV- oder kurzwelligen sichtbaren Licht liegen. Die Bebilderung kann auch mit Elektronen-, Röntgen- oder Laserstrahlung erfolgen. Als Laser werden insbesondere Helium-Neon-Laser, Argon-Laser, Krypton-Laser sowie Helium-Cadmium-Laser genannt.

Die Schichtstärke variiert in Abhängigkeit von ihrem Einsatzgebiet. Sie beträgt zwischen 0,1 und 100 µm, insbesondere zwischen 0,5 und 5 µm.

Die zum Entwickeln verwendeten wäßrig-alkalischen Lösungen abgestufter Alkalität, d.h. mit einem pH-Wert, der bevorzugt bei 10 bis 14 liegt, und die auch kleinere Mengen organischer Lösungs- oder Netzmittel enthalten können, entfernen die belichteten Stellen der Kopierschicht und erzeugen so ein positives Abbild der Vorlage.

Als erfindungsgemäß beansprucht wird ferner ein Verfahren zur Herstellung eines Photoresistmusters. Bei diesem Verfahren wird das erfindungsgemäße positiv arbeitende Aufzeichnungsmaterial durch eine Maskenvorlage bei λ = 365 nm belichtet, mit einem wäßrig alkalischen Entwickler entwickelt und anschließend das Substrat in den ausentwickelten Bildstellen ggf. nach üblichen Methoden dotiert, angeätzt und/oder metallisiert.

Ebenso kann der Photoresist nach der bildmäßigen Belichtung bei λ = 365 nm auf 120° C erhitzt werden und anschließend bei λ = 365 bis 436 nm ganzflächig belichtet werden, bevor er mit einem wäßrig alkalischen Entwickler entwickelt wird. Dieser Bildumkehrprozeß erlaubt die Herstellung kantenscharfer Negativstrukturen.

Die folgenden Beispiele beschreiben bevorzugte Ausführungsformen der Erfindung. Mengenverhältnisse und Prozentzahlen sind, wenn nichts anderes angegeben ist, mit Gewichtseinheiten zu versehen.

### Beispiel 1:

Ein lichtempfindliches Gemisch bestehend aus
3,5 Gt des Veresterungsproduktes aus 1 mol 2,3,4-Trihydroxybenzophenon und 2 mol 1,2-Naphthochinondiazid-5-sulfonylchlorid,
11,5 Gt eines Poly-p-vinylphenols mit einer Glasübergangstemperatur von 165° C,
0,3 Gt 2,2',4,4'-Tetrahydroxybenzophenon,
28,0 Gt Ethylenglykolmonoethyletheracetat,
3,5 Gt n-Butylacetat und
3,5 Gt Xylol
wurde mit 4.000 Umdrehungen pro Minute auf einen Siliciumwafer aufgeschleudert und in einem Umluftofen bei 90° C für 30 Minuten getrocknet. Die 1,9 µm dicke Schicht wurde mit aktinischer Strahlung der Wellenlänge λ = 365 nm durch eine Maskenvorlage hindurch belichtet.

Entwickelt wurde in einer Lösung aus
0,61 Gt Natriummetasilikat x 9 H₂O
0,46 Gt Trinatriumphosphat x 12 H₂O
0,04 Gt Mononatriumphosphat, wasserfrei in
98,89 Gt entionisiertem Wasser.

Nach einer Entwicklungszeit von 60 Sekunden bei 21° C wurden die aufentwickelten Strukturen untersucht. Dabei zeigte sich, daß bei einer Belichtung innerhalb des Bereichs von 167 bis 268 mJ/cm² (Belichtungsspielraum 101 mJ/cm²) kantenscharfe Resiststrukturen einer Breite von 2 µm erhalten wurden.

### Beispiel 2 (Vergleichsbeispiel):

Es wurde ein lichtempfindliches Gemisch entsprechend Beispiel 1 hergestellt, jedoch ohne Farbstoff (UV-Absorber).

Die Entwicklung erfolgte ebenso analog zu Beispiel 1. Die Untersuchung der mikroskopischen Strukturen zeigte, daß bei Belichtung lediglich in einem Bereich von 167 bis 201 mJ/cm², d.h. bei einem Belichtungsspielraum von 34 mJ/cm², 2 µm breite Strukturen erzeugt werden konnten, die jedoch deutliche Kantenrauhigkeiten aufwiesen.

### Beispiel 3:

Ein lichtempfindliches Gemisch bestehend aus
10 Gt eines Kresol-Formaldehyd-Novolaks mit dem Erweichungsbereich von 147-150° C nach DIN 53181
8 Gt einer 50%igen Lösung von Polyvinylmethylether in Toluol
3 Gt 1,2-Naphthochinondiazid-4-sulfonsäureester des 4-(2-Phenyl-prop-2-yl)phenols und
7 Gt 2,2'-Dihydroxy-4,4'-dimethoxybenzophenon in
72 Gt 1-Methoxypropan-2-ol
wurde analog zu Beispiel 1 verarbeitet. Bei der bildmäßigen Belichtung wurden mit Energien von 60 bis 100 mJ/cm² (Belichtungspielraum 40 mJ/cm²) kantenscharfe, 2,0 µm breite Strukturen erzeugt.

### Beispiel 4 (Vergleichsbeispiel):

Es wurde ein lichtempfindliches Gemisch entsprechend Beispiel 3, jedoch ohne Farbstoff (UV-Absorber) gemäß Beispiel 1 verarbeitet. Lediglich bei der bildmäßigen Belichtung mit Energien von 60 bis 88 mJ/cm² (Belichtungsspielraum 28 mJ/cm²) konnten 2,0 µm breite Strukturen erzeugt werden, die jedoch deutliche Kantenrauhigkeiten aufwiesen.

### Beispiel 5:

Es wurde ein lichtempfindiches Gemisch gemäß Beispiel 3 nach dem Aufschleudern und Trocknen analog zu Beispiel 1 mit aktinischer Strahlung der Wellenlängen λ = 365 nm durch eine Maskenvorlage hindurch belichtet. Anschließend wurde die Resistschicht für eine Minute auf 120° C auf einer hotplate erhitzt und abschließend mit aktinischer Strahlung im Bereich von 365 bis 436 nm und mit einer Energie von 200 mJ/cm² ganzflächig belichtet. Entwickelt wurde analog zu Beispiel 1. Es konnten kantenscharfe Negativstrukturen erhalten werden. Der Bildumkehrprozeß wurde daher durch den Zusatz des Farbstoffs nicht beeinträchtigt.

## Patentansprüche

1. Positiv arbeitendes lichtempfindliches Gemisch, enthaltend eine lichtempfindliche Verbindung, ein wasserunlösliches, in wäßrig-alkalischer Lösung aber lösliches bzw. quellbares Bindemittel sowie einen Farbstoff, dadurch gekennzeichnet, daß der Farbstoff eine bei λ = 365 ± 15 nm absorbierende, nicht ausbleichbare Verbindung der allgemeinen Formel I 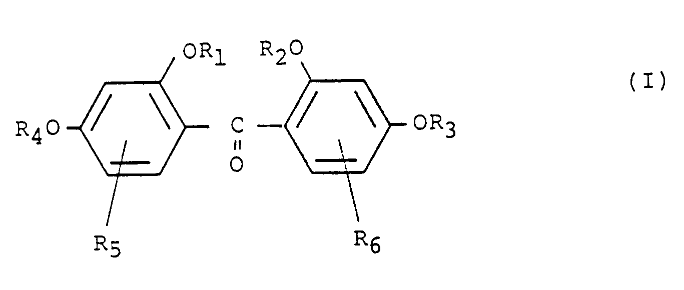 ist, worin
R₁ bis R₄ gleich oder verschieden sind und Wasserstoff, Alkyl, Hydroxyalkyl oder Alkoxyalkyl und
R₅ und R₆ gleich oder verschieden sind und Wasserstoff, Alkyl, Hydroxyalkyl, Alkoxyalkyl, Halogen oder Amino
bedeuten.

2. Lichtempfindliches Gemisch nach Anspruch 1, dadurch gekennzeichnet, daß als lichtempfindliche Verbindung ein o-Chinondiazid enthalten ist.

3. Lichtempfindliches Gemisch nach Anspruch 1, dadurch gekennzeichnet, daß als lichtempfindliche Verbindung ein photolytischer Säurespender in Kombination mit einer säurespaltbaren Verbindung mit einer C-O-C Gruppierung enthalten ist.

4. Lichtempfindliches Gemisch nach Anspruch 3, dadurch gekennzeichnet, daß als photolytischer Säurespender eine organische Halogenverbindung enthalten ist.

5. Lichtempfindliches Gemisch nach einem oder mehreren der Ansprüche 1 bis 4, dadurch gekennzeichnet, daß als Bindemittel ein Novolak-Kondensationsharz enthalten ist.

6. Lichtempfindliches Gemisch nach Anspruch 5, dadurch gekennzeichnet, daß das alkalilösliche Novolak-Kondensationsharz mit bis zu 20 Gew.-% mit anderen Harzen verschnitten ist.

7. Positiv arbeitendes lichtempfindliches Aufzeichnungsmaterial, im wesentlichen bestehend aus einem in der Photoresisttechnik üblichen Träger und einer lichtempfindlichen Schicht, dadurch gekennzeichnet, daß dieses als lichtempfindliche Schicht ein Gemisch entsprechend den Ansprüchen 1 bis 6 enthält.

8. Verfahren zur Herstellung eines Photoresistmusters, dadurch gekennzeichnet, daß ein positiv arbeitendes Aufzeichnungsmaterial gemäß Anspruch 7 durch eine Maskenvorlage bei λ = 365 nm belichtet wird und anschließend entweder mit einem wäßrig alkalischen Entwickler entwickelt wird oder auf 120° C erhitzt und anschließend ganzflächig bei λ = 365 bis 436 nm belichtet wird, woran sich schließlich ein Entwickeln mit einem wäßrig alkalischen Entwickler anschließt.

## Claims

1. Positive-working photosensitive composition comprising a photosensitive compound, a binder that is insoluble in water and soluble or swellable in an aqueous-alkaline solution, and a dye, characterized in that the dye comprises a non-bleachable compound which absorbs light at λ = 365 ± 15 nm and corresponds to the general formula I 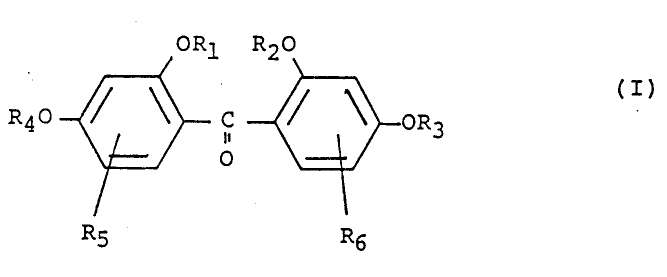 wherein
R₁ to R₄ are identical or different and denote hydrogen, alkyl, hydroxyalkyl or alkoxyalkyl, and
R₅ and R₆ are identical or different and denote hydrogen, alkyl, hydroxyalkyl, alkoxyalkyl, halogen or amino.

2. A photosensitive composition as claimed in claim 1, characterized in that an o-quinone diazide is present as the photosensitive compound.

3. A photosensitive composition as claimed in claim 1, characterized in that a photolytic acid donor in combination with an acid-cleavable compound containing a C-O-C grouping is present as the photosensitive compound.

4. A photosensitive composition as claimed in claim 3, characterized in that an organic halogen compound is present as the photolytic acid donor.

5. A photosensitive composition as claimed in any one or several of claims 1 to 4, characterized in that a novolak condensation resin is present as the binder.

6. A photosensitive composition as claimed in claim 5, characterized in that the alkali-soluble novolak condensation resin is blended with other resins in a proportion of up to 20 % by weight.

7. Positive-working photosensitive recording material essentially comprising a substrate of any of the types conventionally employed for photoresist applications and a photosensitive layer, characterized in that the material comprises a composition as claimed in claims 1 to 6 as the photosensitive layer.

8. Process for the production of a photoresist pattern, characterized in that a positive-working recording material as claimed in claim 7 is exposed through a mask original at λ = 365 nm, whereupon it is either developed with an aqueous-alkaline developer or, alternatively, heated to 120°C, thereafter subjected to an overall exposure at λ = 365 to 436 nm and then developed with an aqueous-alkaline developer.

## Revendications

1. Composition photosensible travaillant en positif, qui contient un composé photosensible, un liant insoluble dans l'eau mais soluble ou gonflable dans une solution alcaline aqueuse, ainsi qu'un colorant, caractérisée en ce que le colorant est un composé non décolorable, absorbant à 365±15 nm, de formule générale I, 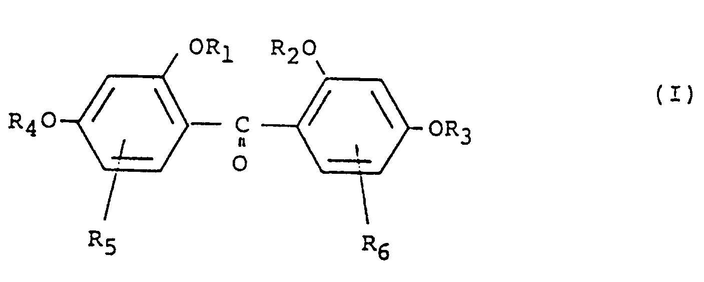 dans laquelle
R₁ à R₄ sont identiques ou différents et représentent l'atome d'hydrogène ou un groupe alkyle, hydroxyalkyle ou alcoxyalkyle, et
R₅ et R₆ sont identiques ou différents et représentent un atome d'hydrogéne ou d'halogène ou un groupe alkyle, hydroxyalkyle, alcoxyalkyle ou amino.

2. Composition photosensible selon la revendication 1, caractérisée en ce qu'elle contient, comme composé photosensible, un o-quinonediazide.

3. Composition photosensible selon la revendication 1, caractérisée en ce qu'elle contient, comme composé photosensible, un donneur photolytique d'acide en combinaison avec un composé clivable par un acide contenant un enchaînement C-O-C.

4. Composition photosensible selon la revendication 3, caractérisée en ce qu'elle contient, comme donneur photolytique d'acide, un composé halogéné organique.

5. Composition photosensible selon une ou plusieurs des revendications 1 à 4, caractérisée en ce qu'elle contient, comme liant, une résine de condensation novolaque.

6. Composition photosensible selon la revendication 5, caractérisée en ce que la résine de condensation novolaque soluble dans une base alcaline est mélangée à d'autres résines, à raison de jusqu'à 20 % en poids.

7. Matériau d'enregistrement photosensible travaillant en positif, essentiellement constitué d'un substrat courant dans la technique des photorésists et d'une couche photosensible, caractérisé en ce que ledit matériau comprend, comme couche photosensible, une composition correspondant aux revendications 1 à 6.

8. Procédé de fabrication d'un modèle de photorésist, caractérisé en ce qu'un matériau d'enregistrement travaillant en positif de la revendication 7 est exposé à travers un original masque, à une longueur d'onde de 365 nm, puis est soit développé avec un développateur alcalin aqueux, soit chauffé à 120°C puis exposé sur toute sa surface, à une longueur d'onde comprise entre 365 et 436 nm, et développé ensuite avec un développateur alcalin aqueux.
